# EUROPEAN PATENT SPECIFICATION

(11) **EP 4 618 417 B1**
(45) Date of publication and mention of the grant of the patent: **02.12.2026**
(21) Application number: 24163849.3
(22) Date of filing: 15.03.2024
(51) Int. Cl.: H03K 17/06, H03K 17/0812, H03K 17/284, H03K 17/689

(54) **AIRCRAFT SOLID STATE POWER CONTROLLER, AIRCRAFT COMPRISING AN AIRCRAFT SOLID STATE POWER CONTROLLER, AND METHOD OF OPERATING AN AIRCRAFT SOLID STATE POWER CONTROLLER**
FLUGZEUGFESTKÖRPERLEISTUNGSREGLER, FLUGZEUG MIT EINEM FLUGZEUGFESTKÖRPERLEISTUNGSREGLER UND VERFAHREN ZUM BETRIEB EINES FLUGZEUGFESTKÖRPERLEISTUNGSREGLERS
CONTRÔLEUR DE PUISSANCE À L'ÉTAT SOLIDE D'UN AÉRONEF, AÉRONEF COMPRENANT UN CONTRÔLEUR DE PUISSANCE À L'ÉTAT SOLIDE ET PROCÉDÉ DE FONCTIONNEMENT D'UN CONTRÔLEUR DE PUISSANCE À L'ÉTAT SOLIDE D'UN AÉRONEF

(43) Date of publication of application: 17.09.2025
(73) Proprietor: HS Elektronik Systeme GmbH, 86720 Noerdlingen (DE)
(72) Inventor: Holzrichter, Jakob, 73453 Abtsgmünd (DE)
(74) Representative: Schmitt-Nilson Schraud Waibel Wohlfrom Patentanwälte Partnerschaft mbB

(56) References cited:
- US-A1- 2023 101 061
- US-B2- 11 165 422
- US-B2- 8 710 872

## Description

The present invention is related to an aircraft solid state power controller. The present invention is further related to an aircraft comprising a solid state power controller, and to a method of operating a solid state power controller.

Modern aircraft usually comprise an electric system including at least one aircraft electric power supply system for supplying electric power, which is supplied with a power supply voltage, from at least one electric power source to at least one electric load. The electric system further includes at least one aircraft solid state power controller, which is configured for controlling the supply of electric power from the at least one electric power source to the at least one electric load.

In some configurations, it is desirable to control the at least one aircraft solid state power controller with an electric control signal, which is provided as an additional voltage with reference to the power supply voltage. It further may be desirable to galvanically isolate the electric control signal be from the at least one electric power source.

It would therefore be beneficial to provide an aircraft solid state power controller, which allows for controlling the supply of electric power from at least one electric power source to at least one electric load with an electric control signal, wherein the electric control signal is applied as an additional voltage with reference to the power supply voltage and wherein the electric control signal is galvanically isolated from the at least one electric power source.

US 8 710 872 B2, US 2023/101061 A1 and US 11 165 422 B2 disclose prior art solid state power controllers.

According to an exemplary embodiment of the invention, an aircraft solid state power controller for controlling the supply of electric power to an electric load in an aircraft, wherein the electric load is electrically connected between an output terminal of the aircraft solid state power controller and a ground potential, comprises a solid state switch and an isolated gate driver.

The solid state switch is arranged between and electrically connected to a power supply line and the output terminal of the aircraft solid state power controller for selectively supplying or interrupting supply of electric power having a first voltage, which is measured between the power supply line and the ground potential, to the load in response to a control signal, which is provided to a control terminal of the aircraft solid state power controller. The control signal has a second voltage with reference to the power supply line, with the second voltage being applied as an additional voltage on top of the first voltage with respect to the ground potential. The isolated gate driver comprises an input side and an output side. The output side is galvanically isolated from the input side. A reference potential of the output side of the isolated gate driver is electrically coupled to the output terminal of the aircraft solid state power controller. In consequence, the reference potential of the output side of the isolated gate driver is electrically coupled to the ground potential only via the load. As a result, the reference potential differs from the ground potential, when the solid state switch is switched on, allowing an electric current to flow through the load.

The isolated gate driver is configured for receiving the control signal on its input side, and for supplying a drive signal to the solid state switch on its output side upon receiving the control signal on its input side. A gate driver supply voltage for driving the output side of the isolated gate driver is supplied to the output side of the isolated gate driver with respect to the reference potential.

The aircraft solid state power controller further comprises a voltage regulator, which is configured for at least temporarily limiting the isolated gate driver supply voltage that is applied to the output side of the isolated gate driver.

Exemplary embodiments of the invention also include a method of operating an aircraft solid state power controller for controlling the supply of electric power to an electric load in an aircraft, with the electric load being electrically connected between an output terminal of the aircraft solid state power controller and a ground potential, wherein the aircraft solid state power controller comprises: a solid state switch and an isolated gate driver. The solid state switch is arranged between and electrically connected to a power supply line and the output terminal of the aircraft solid state power controller for selectively supplying or interrupting supply of electric power having a first voltage, which is measured between the power supply line and the ground potential, to the load in response to a control signal, which is provided at a control terminal of the aircraft solid state power controller. The control signal has a second voltage with reference to the power supply line, with the second voltage being applied as an additional voltage on top of the first voltage with respect to the ground potential.

The isolated gate driver comprises an input side and an output side. The output side is galvanically isolated from the input side. A reference potential of the output side of the isolated gate driver is electrically coupled to the output terminal of the aircraft solid state power controller. In consequence, the reference potential of the output side of the isolated gate driver is electrically coupled to the ground potential only via the load. As a result, the reference potential differs from the ground potential, when the solid state switch is switched on, allowing an electric current to flow through the load.

The method includes supplying a gate driver supply voltage for driving the output side of the isolated gate driver to the output side of the isolated gate driver with respect to the reference potential; at least temporarily limiting the isolated gate driver supply voltage that is supplied to the output side of the isolated gate driver. The method further includes supplying a drive signal from the output side of the isolated gate driver to the solid state switch, when a control signal is received on the control terminal of the aircraft solid state power controller.

An aircraft solid state power controller and a method of operating an aircraft solid state power controller according to exemplary embodiments of the invention allow for safely and reliably operating an aircraft solid state power controller, which may in particular include switching a solid state switch of the aircraft solid state power controller, based on a control signal, which is applied as an additional voltage with reference to the power supply voltage provided by the electric power source, wherein the electric control signal is galvanically isolated from the at least one electric power source. An aircraft solid state power controller and a method of operating an aircraft solid state power controller according to an exemplary embodiments of the invention, may in particular prevent the isolated gate driver of the aircraft solid state power controller from being damaged due to overvoltages and/or negative voltages supplied to the output side of the isolated gate driver, exceeding the specifications of the isolated gate driver.

The first voltage, which is provided by the electric power source, may be in the range of 25 V to 30 V. The first voltage may in particular be 28 V, which is a typical voltage used in aircraft power supply systems 2.

The second voltage of the control signal may be in the range of 1 V to 5 V. The second voltage may in particular be 3.3 V

The voltage regulator may comprise a Zener diode for providing a defined gate driver supply voltage. The voltage regulator may further comprise at least one transistor, in particular at least one bipolar transistor, in order to enable the voltage regulator to provide substantial electric currents at the gate driver supply voltage.

The voltage regulator may be configured for at least temporarily limiting the isolated gate driver supply voltage to a voltage in the range of between 8 V and 20 V. The specified gate driver supply voltages of isolated gate drivers are typically in the range of between 8 V and 20 V. Thus, limiting the isolated gate driver supply voltage to a voltage in the range of between 8 V and 20 V allows for employing a large number of commercially available isolated gate drivers.

The aircraft solid state power controller may comprise a gate driver power supply switching circuit, which is configured for selectively activating and deactivating the supply of the isolated gate driver supply voltage to the output side of the isolated gate driver in response to the control signal. Selectively deactivating the supply of the isolated gate driver supply voltage, when the isolated gate driver is not used, and activating the isolated gate driver supply voltage only, when the isolated gate driver is needed for driving the solid state switch, may allow for preventing undesirable leak currents to flow through the isolated gate driver and the load, when the solid state switch is switched off.

The aircraft solid state power controller may comprise a delay circuit, which is configured for supplying an activation signal for activating the gate driver power switching circuit without considerable delay for supplying electric power to the output side of the isolated gate driver upon receiving the control signal. The delay circuit may further be configured for forwarding the received control signal to an input terminal of the isolated gate driver with a first predefined delay. Employing such a delay circuit may allow for ensuring that the isolated gate driver is fully activated, before the control signal is applied to the input terminal of the isolated gate driver.

This may enhance the operational reliability of the aircraft solid state power controller.

The first predefined delay may be in the range of between 1 microsecond and 50 microseconds. The first predefined delay may in particular be approximately 10 microseconds. Such a delay has been found as sufficient for allowing for a safe and reliable operation of the aircraft solid state power controller.

The delay circuit may further be configured for stopping, without considerably delay, forwarding the control signal to the input terminal of the isolated gate driver, when no control signal is received on the control terminal of the aircraft solid state power controller anymore. The delay circuit may further be configured for continuing to supply the activation signal to the gate driver power supply switching circuit for a second predefined delay, after no control signal is received on the control terminal of the aircraft solid state power controller anymore. Employing such a delay circuit may prevent the isolated gate driver from being deactivated before the solid state switch has been completely switched off. This may enhance the operational reliability and the operational safety of the aircraft solid state power controller even further.

The second predefined delay may be in the range of between 1 microsecond and 50 microseconds. The second predefined delay may in particular be approximately 10 microseconds. Such a delay has been found as sufficient for allowing for a safe and reliable shut-off of the solid state switch.

The first and second predefined delays may be identical, or they may differ from each other.

The at least one solid state power switch may be or may include a field-effect-transistor, in particular a MOSFET. Field-effect-transistor, in particular MOSFETs, have been found to provide reliable solid state power switch, which are able to reliably switch high current, and which may be provided at low costs.

The aircraft solid state power controller may comprise a plurality of solid state power switches, a plurality of gate driver circuits and a plurality of voltage controllers in order to allow for switching a plurality of electric loads.

Exemplary embodiments of the invention also include an aircraft, such as an airplane or a helicopter, which is equipped with an aircraft electric power supply system including at least one aircraft solid state power controller according to an exemplary embodiment of the invention. The additional features, modifications and effects, which have described above with respect to an aircraft solid state power controller and/or with respect to a method of switching operating an aircraft solid state power controller, apply to such an aircraft in an analogous manner.

In the following, an exemplary embodiment of an aircraft electric power supply system will be described is described in more detail with reference to the enclosed figures.
Figure 1 depicts a schematic side view of an aircraft comprising an aircraft electric power supply system according to an exemplary embodiment of the invention.
Figure 2 depicts a schematic view of an aircraft solid state power controller according to an exemplary embodiment of the invention.

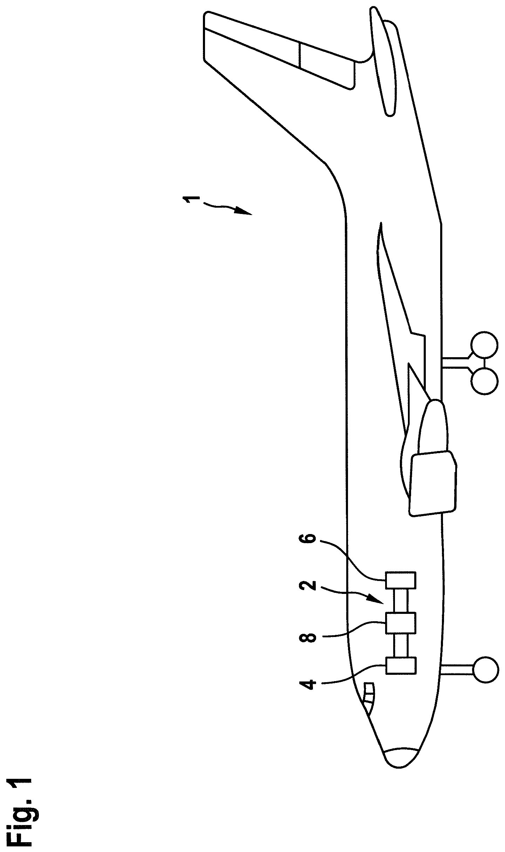

Figure 1 shows a schematic view of an aircraft 1, in particular of an airplane, which is equipped with an aircraft electric power supply system 2 including an aircraft electric power source 4, an electric load 6, and an aircraft solid state power controller (SSPC) 8. The aircraft solid state power controller 8 is configured for controlling the supply of electric power from the aircraft electric power source 4 to the electric load 6.

Although the aircraft electric power supply system 2, as it is depicted in Figure 1, comprises only a single aircraft electric power source 4, a single electric load 6, and a single aircraft solid state power controller 8, respectively, it is to be understood that this is for purpose of illustration only. In practice, embodiments of an aircraft electric power supply system 2 may comprise more the one of each of said components, respectively. Typically, embodiments of an aircraft power supply system 2 may include numerous electric loads 6 and numerous aircraft solid state power controllers 8. An aircraft 1 may also comprise multiple aircraft electric power supply systems 2. Multiple aircraft electric power supply systems 2 may be operated with the same voltage or with different voltages.

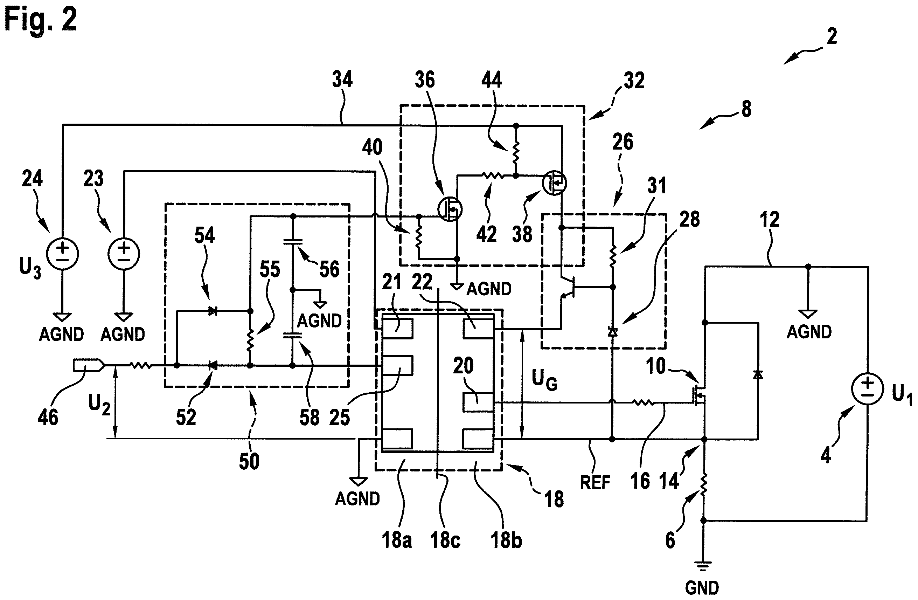

Figure 2 depicts a schematic circuit diagram of an aircraft electric power supply system 2 according to an exemplary embodiment of the invention, comprising an aircraft solid state power controller 8, which is electrically coupled to an aircraft electric power source 4 and an electric load 6.

The aircraft electric power source 4 may in particular be a DC power source 4 providing a first DC voltage U1, for example a first DC voltage U1 of 28 V, on a power supply line 12 with respect to an electric ground GND.

The aircraft solid state power controller 8 comprises a solid state switch 10, which is connected between the power supply line 12 and an output terminal 14 of the aircraft solid state power controller 8.

The electric load 6 is electrically connected between the output terminal 14 of the aircraft solid state power controller 8 and the electric ground GND.

The solid state switch 10 may be switched between an ON-state, in which electric power from the aircraft electric power source 4 is supplied via the power supply line 12 and the solid state switch 10 to the electric load 6, and an OFF-state, in which no electric power is supplied from the aircraft electric power source 4 to the electric load 6.

The solid state switch 10 may be a field effect transistor, in particular a MOSFET.

The solid state switch 10 may in particular comprise a drive terminal 16, which may, for example, be electrically connected to a gate of a MOSFET, and the solid state switch 10 may be switched between the ON-state and the OFF-state in response to a drive signal, which is applied to the drive terminal 16 of the solid state switch 10.

In the embodiment depicted in Figure 2, the drive signal is driven by a control signal, which is provided at a control terminal 46 of the aircraft solid state power controller 8.

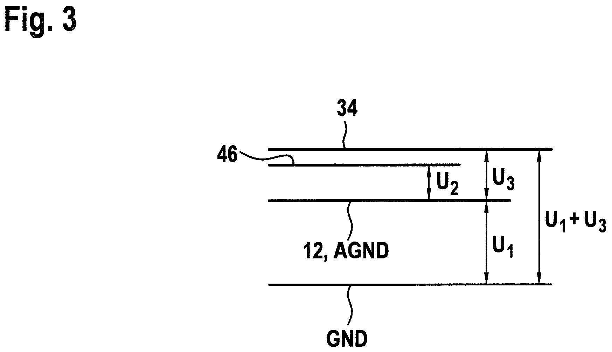

The control signal may in particular have a second voltage U2 with reference to the potential AGND of the power supply line 12. In other words, with reference to the electric ground GND, the second voltage U2 of the control signal is applied as an additional voltage on top of the first voltage U1, as it is schematically depicted in Figure 3. The second voltage U2 may be in the range between 1 V and 5 V, the second voltage may in particular be 3.3 V.

In order to provide a galvanic isolation between the input side and the output side of the aircraft solid state power controller 8, the control signal, which is provided at the control terminal 46 of the aircraft solid state power controller 8, is converted into the drive signal, which is applied to the drive terminal 16 of the solid state switch 10, by an isolated gate driver 18.

The isolated gate driver 18 comprises an input side 18a with an input terminal 25 for receiving the control signal provided at the control terminal 46, and an output side 18b with a drive output terminal 20, which is electrically connected to the drive terminal 16 of the solid state switch 10.

Optionally, the isolated gate driver 18 may comprise two drive output terminals 20; a first drive output terminal 20 for switching on the solid state switch 10; and a second drive output terminal 20 for switching off the solid state switch 10.

The input side 18a and the output side 18b are galvanically isolated from each other by an electrically isolating barrier 18c. The isolated gate driver 18 may, for example, include an optocoupler.

The drive signal is output on the drive output terminal 20, when the control signal is received on the input terminal 25 of the isolated gate driver 18. Correspondingly, no drive signal is output on the drive output terminal 20, when no control signal is received on the input terminal 25.

An output side reference potential REF of the output side 18b of the isolated gate driver 18 is electrically coupled to the output terminal 14 of the solid state switch 10. The drive signal, which is output at the drive output terminal 20 of the isolated gate driver 18 is provided with reference to said output side reference potential REF, which is identical to the potential at the output terminal 14 of the solid state switch 10.

Electric power for operating the input side 18a of the isolated gate driver 18 is supplied by a first auxiliary power supply 23 to an input side power supply input 21 of the isolated gate driver 18 with reference to the potential AGND of the power supply line 12. The voltage of the electric power supplied by the first auxiliary power supply 23 may, for example, be in the range of 1 V to 5 V in particular 3.3 V. The voltage of the electric power supplied by the first auxiliary power supply 23 may be identical to the second voltage.

Electric power for operating the output side 18b of the isolated gate driver 18 is provided by a second auxiliary power supply 24 to an output side power supply input 22 with reference to the output side reference potential REF. The voltage U3 of the electric power provided by the second auxiliary power supply 24 may be in the range of 10 V to 15 V.

In Figure 2, the first auxiliary power supply 23 and the second auxiliary power supply 24 are depicted a two separate auxiliary power supplies 23, 24. It is also possible that both, the electric power for operating the input side 18a and the electric power for operating the output side 18b of the isolated gate driver 18, are provided by the same auxiliary power supply 23, 24.

When the solid state switch 10 is switched off, the output terminal 14 of the solid state switch 10 is, via the electric load 6, on the same potential as the electric ground GND, and the isolated gate driver supply voltage UG, which is applied to the output side power supply input 22 of the isolated gate driver 18 is the sum of the first voltage U1 provided by the aircraft electric power source 4 and the additional voltage U3 provided by the second auxiliary power supply 24: UG = U1 + U3, as it schematically depicted in Figure 3.

In case, for example, the first voltage U1 provided by the aircraft electric power source 4 is 28 V, and the additional voltage U3 provided by the second auxiliary power supply 24 is 12 V, a total gate driver supply voltage UG of 28 V + 12 V = 40 V is applied to the output side power supply input 22 of the isolated gate driver 18 with reference to the output side reference potential REF. Providing such a relatively high gate driver supply voltage UG at the output side power supply input 22 of the isolated gate driver 18 may exceed the specification of the isolated gate driver 18.

In order to prevent the isolated gate driver 18 from being damaged by such a relatively high gate driver supply voltage UG provided at the output side power supply input 22 of the isolated gate driver 18, the aircraft solid state power controller 8 comprises a voltage regulator 26. The voltage regulator 26 is configured for at least temporarily limiting the isolated gate driver supply voltage UG that is applied to the output side of the output side power supply input 22 of the isolated gate driver 18.

In the embodiment depicted in Figure 2, the voltage regulator 26 comprises a Zener diode 28, a bipolar transistor 30, and a resistor 31. The breakthrough voltage of the Zener diode 28 is selected so that the maximum voltage applied to the output side power supply input 22 of the isolated gate driver 18 with reference to the output side reference potential REF does not exceed the specification of the isolated gate driver 18.

As a result, the voltage regulator 26 allows for a safe operation of the isolated gate driver 18 by preventing the isolated gate driver 18 from being damaged by applying too high voltages to the output side 18b of the isolated gate driver 18.

In order to avoid leak currents flowing through the output side 18b of the isolated gate driver 18 and the load 6 when the solid state switch 10 is switched off, the output side 18b of the isolated gate driver 18 may be activated only, when it is needed for driving the solid state switch 10. In other words, the supply of electric power to the output side power supply input 22 of the isolated gate driver 18 may be switched off, when no control signal is present at the control terminal 46.

For controlling the electric power applied to the output side power supply input 22 of the isolated gate driver 18, the aircraft solid state power controller 8 comprises a power supply switching circuit 32, which is arranged along an output side power supply line 34 extending between the second auxiliary power supply 24 and the voltage regulator 26.

The power supply switching circuit 32 comprises two field effect transistors 36, 38 and three resistors 40, 42, 44, as depicted in Figure 2.

The power supply switching circuit 32 is in particular a complementary built MOSFET logic. When the gate of the first field effect transistor 36 is switched on, the gate of the second field effect transistor 38 is grounded to the potential AGND of the power supply line 12 via resistor 42, and electric power from the second auxiliary power supply 24 is supplied to the voltage regulator 26. Resistor 40 is a pull-down resistor for grounding the gate of the first field effect transistor 36 to the potential AGND of the power supply line 12, when no signal is applied to its gate. Resistor 44 is a pull-up resistor to switch off the second field effect transistor 38, when no gate signal is applied. Resistor 42 limits the electric current flowing through the gate of the second field effect transistor 38. Resistor 42 also limits the voltage increase at the collector of the bipolar transistor 30 of the voltage regulator 26.

The power supply switching circuit 32 is controlled by the control signal, which is provided at the control terminal 46 of the aircraft solid state power controller 8.

A control signal, which is applied to the control terminal 46 of the aircraft solid state power controller 8, is also applied to the input terminal 25 of the isolated gate driver 18. When the isolated gate driver 18 receives the control signal on its input terminal 25, the isolated gate driver 18 outputs a drive signal for activating the solid state switch 10 on the drive output terminal 20.

In order to ensure that the isolated gate driver 18 has been fully activated before the control signal is applied to its input terminal 25, the aircraft solid state power controller 8 comprises a delay circuit 50. The delay circuit 50 is arranged between the input terminal 46 of the aircraft solid state power controller 8 and the input terminal 25 of the isolated gate driver 18.

The delay circuit 50 comprises two semiconductor diodes 52, 54, two capacitors 56, 58, and a resistor 44, as depicted in Figure 2.

The delay circuit 50 is configured for activating the gate driver power switching circuit 32 without considerable delay, when a control signal is provided on the input terminal 46, for supplying electric power to the output side power supply input 22 of the isolated gate driver 18.

The delay circuit 50 is further configured for forwarding the control signal provided on the input terminal 46 of the aircraft solid state power controller 8 to the input terminal 25 of the isolated gate driver 18 with a first predefined delay T1. Forwarding the control signal received on the input terminal 46 of the aircraft solid state power controller 8 to the input terminal 25 of the isolated gate driver 18 with a first predefined delay T1 allows for activating the gate driver power switching circuit 32 and, as a result, fully activating the isolated gate driver 18, before the control signal is applied to the input terminal 25 of the isolated gate driver 18.

The delay circuit 50 may be configured for delaying the control signal for a first predefined delay T1, which may be in the range of between 1 microsecond and 50 microseconds. The first predefined delay T1 may in particular be approximately 10 microseconds.

When the control signal provided at the input terminal 46 of the aircraft solid state power controller 8 is switched off so that no control signal is applied to the input terminal 25 of the isolated gate driver 18 anymore, no drive signal is output on the drive output terminal 20 of the isolated gate driver 18 for driving the solid state switch 10. As a result, the solid state switch 10 is switched off, and the supply of electric power from the power supply line 12 to the electric load 6 is interrupted.

In order to ensure that the solid state switch 10 is switched off properly, the isolated gate driver 18 may remain active at least until the solid state switch 10 has been completely switched off. In order to maintain the isolated gate driver 18 active after the control signal at the input terminal 46 has been switched off, the delay circuit 50 is configured for continuing to supply an activation signal to the gate driver power switching circuit 32 for a second predefined delay T2, after the control signal at the input terminal 46 has been switched off.

The delay circuit 50 may be configured for continuing to supply the activation signal to the gate driver power switching circuit 32 for a second predefined delay T2, which may be in the range of between 1 microsecond and 50 microseconds The second predefined delay T2 may in particular be approximately 10 microseconds.

The first predefined delay T1 and second predefined delay T2 may be identical, or they may differ from each other.

An aircraft solid state power controller 8 according to an exemplary embodiment of the invention, as it is depicted in Figure 2, allows for a safe an reliable switching of the solid state switch 10 based on an input signal, which applied to the input terminal 46 of the aircraft solid state power controller 8 with reference to the potential AGND of the power supply line 12 supplying electric power from the aircraft electric power source 4 to the aircraft solid state power controller 8, with the input signal being galvanically isolated from the aircraft electric power source 4.

While the invention has been described with reference to an exemplary embodiment, it will be understood by those skilled in the art that various changes may be made and equivalents may be substituted for elements thereof without departing from the scope of the invention. In addition, modifications may be made to adapt a particular situation or material to the teachings of the invention without departing from the essential scope thereof. Therefore, it is intended that the invention is not limited to the particular embodiment disclosed, but that the invention will include all embodiments falling within the scope of the appended claims.

## Claims

1. Aircraft solid state power controller (8) configured for controlling the supply of electric power to an electric load (6) in an aircraft (1), wherein the electric load (6) is electrically connected between an output terminal (14) of the aircraft solid state power controller (8) and a ground potential (GND);
the aircraft solid state power controller (8) comprising:
a solid state switch (10), which is arranged between and electrically connected to a power supply line (12) and the output terminal (14) of the aircraft solid state power controller (8) and configured for selectively supplying or interrupting supply of electric power having a first voltage (U1) between the power supply line (12) and the ground potential (GND), to the electric load (6) in response to a control signal provided at a control terminal (46) of the aircraft solid state power controller (8); wherein the control signal has a second voltage (U2) with reference to the power supply line (12) and the aircraft solid state power controller (8) is configured for applying the second voltage (U2) as an additional voltage on top of the first voltage (U1) with respect to the ground potential (GND); and
an isolated gate driver (18), comprising an input side (18a) and an output side (18b), wherein the output side (18b) is galvanically isolated from the input side (18a) and wherein a reference potential of the output side (18b) of the isolated gate driver (18) is electrically coupled to the output terminal (14) of the aircraft solid state power controller (8);
wherein the isolated gate driver (18) is configured for receiving the control signal on its input side (18a), and for supplying a drive signal to the solid state switch (10) on its output side (18b) upon receiving the control signal on its input side (18a);
wherein the aircraft solid state power controller (8) is configured for supplying a gate driver supply voltage (UG) for driving the output side (18b) of the isolated gate driver (18) to the output side (18b) of the isolated gate driver (18) with respect to the reference potential.

2. Aircraft solid state power controller (8) according to claim 1, wherein the aircraft solid state power controller (8) further comprises a voltage regulator (26), which is configured for at least temporarily limiting the gate driver supply voltage (UG) that is applied to the output side (18b) of the isolated gate driver (18).

3. Aircraft solid state power controller (8) according to claim 1 or 2, wherein the first voltage (U1) is in the range of 25 V to 30 V, wherein the first voltage (U1) is in particular 28 V; and/or wherein the second voltage (U2) is in the range of 1 V to 5 V, wherein the second voltage (U2) is in particular 3.3 V.

4. Aircraft solid state power controller (8) according to any of claims 1 to 3,
wherein the voltage regulator (26) comprises a Zener diode (28) and/or at least one transistor (30), in particular at least one bipolar transistor (30),
wherein the voltage regulator (26) is in particular configured for at least temporarily limiting the gate driver supply voltage (UG) to a voltage in the range of between 20 V and 30 V.

5. Aircraft solid state power controller (8) according to any of the preceding claims, further comprising:
a gate driver power supply switching circuit (32), which is configured for selectively activating and deactivating the supply of the gate driver supply voltage (UG) to the output side (18b) of the isolated gate driver (18) in response to the control signal.

6. Aircraft solid state power controller (8) according to claim 5, further comprising a delay circuit (50), wherein the delay circuit (50) is configured
for supplying an activation signal for activating the gate driver power supply switching circuit (32) without considerable delay for supplying electric power to the output side (18b) of the isolated gate driver (18) upon receiving the control signal; and
for forwarding the received control signal to an input terminal (25) of the isolated gate driver (18) with a first predefined delay (T1).

7. Aircraft solid state power controller (8) according to claim 6, wherein the delay circuit (50) is further configured for
stopping forwarding the control signal to the input terminal (25) of the isolated gate driver (18) without considerably delay, when no control signal is received on the control terminal (46) of the aircraft solid state power controller (8) anymore; and
continuing to supply the activation signal to the gate driver power supply switching circuit (32) for a second predefined delay (T2), when no control signal is received on the control terminal (46) of the aircraft solid state power controller (8) anymore.

8. Aircraft solid state power controller (8) according to claim 6 or 7,
wherein the first predefined delay (T1) is in the range of between 1 microsecond and 50 microseconds, wherein the first predefined delay (T1) is in particular 10 approximately microseconds; and/or
wherein the second predefined delay (T2) is in the range of between 1 microsecond and 50 microseconds, wherein the second predefined delay (T2) is in particular approximately 10 microseconds.

9. Aircraft solid state power controller (8) according to any of the preceding claims, wherein the at least one solid state switch (10) is or includes a field-effect-transistor, in particular a MOSFET.

10. Aircraft solid state power controller (8) according to any of the preceding claims, comprising a plurality of solid state switches (10), a plurality of isolated gate drivers (18) and a plurality of voltage regulators (26).

11. Aircraft (1) comprising at least one electric power source and at least one aircraft solid state power controller (8) according to any of the preceding claims.

12. Method of operating an aircraft solid state power controller (8) for controlling the supply of electric power to an electric load (6) in an aircraft the electric load (6) being electrically connected between an output terminal (14) of the aircraft solid state power controller (8) and a ground potential (GND);
wherein the aircraft solid state power controller (8) comprises:
a solid state switch (10) arranged between and electrically connected to a power supply line (12) and the output terminal (14) of the aircraft solid state power controller (8) for selectively supplying or interrupting supply of electric power having a first voltage (U1), which is measured between the power supply line (12) and the ground potential (GND), to the electric load (6) in response to a control signal, which is provided at a control terminal (46) of the aircraft solid state power controller (8); wherein the control signal has a second voltage (U2) with reference to the power supply line (12) and the second voltage (U2) is applied as an additional voltage on top of the first voltage (U1) with respect to the ground potential (GND);
an isolated gate driver (18), comprising an input side (18a) and an output side (18b), wherein the output side (18b) is galvanically isolated from the input side (18a) and wherein a reference potential of the output side (18b) of the isolated gate driver (18) is electrically coupled to the output terminal (14) of the aircraft solid state power controller (8);
wherein the method includes:
supplying a gate driver supply voltage (UG) for driving the output side (18b) of the isolated gate driver (18) to the output side (18b) of the isolated gate driver (18) with respect to the reference potential;
and
upon receiving the control signal on the control terminal (46) of the aircraft solid state power controller (8), supplying a drive signal from the output side (18b) of the isolated gate driver (18) to the solid state switch (10).

13. Method according to claim 12, wherein the method comprises at least temporarily limiting the gate driver supply voltage (UG) that is supplied to the output side (18b) of the isolated gate driver (18).

14. Method according to claim 12 or 13, further comprising, wherein the method includes
supplying the gate driver supply voltage (UG) to the output side (18b) of the isolated gate driver (18), when the control signal is received on the control terminal (46) of the isolated gate driver (18); and
interrupting the supply of the gate driver supply voltage (UG) to the output side (18b) of the isolated gate driver (18), when no control signal is received on the control terminal (46) of the isolated gate driver (18).

15. Method of claims 14, wherein the method includes, upon receiving the control signal on the control terminal (46) of the aircraft solid state power controller (8):
applying, without considerable delay, an activation signal to the gate driver power supply switching circuit (32) for activating the gate driver power supply switching circuit (32); and
forwarding control signal to an input terminal (25) of the isolated gate driver (18) with a first predefined delay (T1)
, wherein the method in particular includes:
immediately stopping to applying a control signal to the input terminal (25) of the isolated gate driver (18), when no control signal is received on the control terminal (46) of the aircraft solid state power controller (8) anymore;
continuing to supply the activation signal to the gate driver power supply switching circuit (32) for a second predefined delay (T2), when no control signal is received on the control terminal (46) of the aircraft solid state power controller (8) anymore.

## Patentansprüche

1. Luftfahrzeug-Festkörper-Leistungsregler (8), der dazu konfiguriert ist, die Zufuhr von elektrischer Energie zu einer elektrischen Last (6) in einem Luftfahrzeug (1) zu steuern, wobei die elektrische Last (6) zwischen einem Ausgangsanschluss (14) des Luftfahrzeug-Festkörper-Leistungsreglers (8) und einem Massepotential (GND) elektrisch verbunden ist;
wobei der Luftfahrzeug-Festkörper-Leistungsregler (8) umfasst:
einen Festkörperschalter (10), der zwischen einer Stromversorgungsleitung (12) und dem Ausgangsanschluss (14) des Luftfahrzeug-Festkörper-Leistungsreglers (8) angeordnet und mit diesen elektrisch verbunden ist und dazu konfiguriert ist, eine Zufuhr von elektrischer Energie, die eine erste Spannung (U1) zwischen der Stromversorgungsleitung (12) und dem Massepotential (GND) aufweist, zu der elektrischen Last (6) als Reaktion auf ein Steuersignal, das an einem Steueranschluss (46) des Luftfahrzeug-Festkörper-Leistungsreglers (8) bereitgestellt wird, selektiv zuzuführen oder zu unterbrechen; wobei das Steuersignal eine zweite Spannung (U2) in Bezug auf die Stromversorgungsleitung (12) aufweist und der Luftfahrzeug-Festkörper-Leistungsregler (8) dazu konfiguriert ist, die zweite Spannung (U2) als eine zusätzliche Spannung auf die erste Spannung (U1) in Bezug auf das Massepotential (GND) anzulegen; und
einen isolierten Gate-Treiber (18), der eine Eingangsseite (18a) und eine Ausgangsseite (18b) umfasst, wobei die Ausgangsseite (18b) von der Eingangsseite (18a) galvanisch isoliert ist und wobei ein Referenzpotential der Ausgangsseite (18b) des isolierten Gate-Treibers (18) mit dem Ausgangsanschluss (14) des Luftfahrzeug-Festkörper-Leistungsreglers (8) elektrisch gekoppelt ist;
wobei der isolierte Gate-Treiber (18) dazu konfiguriert ist, das Steuersignal auf seiner Eingangsseite (18a) zu empfangen und nach dem Empfangen des Steuersignals auf seiner Eingangsseite (18a) dem Festkörperschalter (10) auf seiner Ausgangsseite (18b) ein Treibersignal zuzuführen;
wobei der Luftfahrzeug-Festkörper-Leistungsregler (8) dazu konfiguriert ist, eine Gate-Treiber-Versorgungsspannung (UG) zum Antreiben der Ausgangsseite (18b) des isolierten Gate-Treibers (18) der Ausgangsseite (18b) des isolierten Gate-Treibers (18) in Bezug auf das Referenzpotential zuzuführen.

2. Luftfahrzeug-Festkörper-Leistungsregler (8) nach Anspruch 1, wobei der Luftfahrzeug-Festkörper-Leistungsregler (8) ferner einen Spannungsregler (26) umfasst, der dazu konfiguriert ist, die Gate-Treiber-Versorgungsspannung (UG), die an die Ausgangsseite (18b) des isolierten Gate-Treibers (18) angelegt wird, zumindest vorübergehend zu begrenzen.

3. Luftfahrzeug-Festkörper-Leistungsregler (8) nach Anspruch 1 oder 2, wobei die erste Spannung (U1) in dem Bereich von 25 V bis 30 V liegt, wobei die erste Spannung (U1) insbesondere 28 V ist; und/oder wobei die zweite Spannung (U2) in dem Bereich von 1 V bis 5 V liegt, wobei die zweite Spannung (U2) insbesondere 3,3 V ist.

4. Luftfahrzeug-Festkörper-Leistungsregler (8) nach einem der Ansprüche 1 bis 3,
wobei der Spannungsregler (26) eine Zener-Diode (28) und/oder mindestens einen Transistor (30), insbesondere mindestens einen Bipolartransistor (30), umfasst,
wobei der Spannungsregler (26) insbesondere dazu konfiguriert ist, die Gate-Treiber-Versorgungsspannung (UG) zumindest vorübergehend auf eine Spannung in dem Bereich zwischen 20 V und 30 V zu begrenzen.

5. Luftfahrzeug-Festkörper-Leistungsregler (8) nach einem der vorhergehenden Ansprüche, ferner umfassend:
eine Gate-Treiber-Stromversorgungs-Schaltschaltung (32), die dazu konfiguriert ist, die Zufuhr der Gate-Treiber-Versorgungsspannung (UG) zu der Ausgangsseite (18b) des isolierten Gate-Treibers (18) als Reaktion auf das Steuersignal selektiv zu aktivieren und zu deaktivieren.

6. Luftfahrzeug-Festkörper-Leistungsregler (8) nach Anspruch 5, ferner umfassend eine Verzögerungsschaltung (50), wobei die Verzögerungsschaltung (50) dazu konfiguriert ist zum Zuführen eines Aktivierungssignals zum Aktivieren der Gate-Treiber-Stromversorgungs-Schaltschaltung (32) ohne erhebliche Verzögerung zum Zuführen von elektrischer Energie zu der Ausgangsseite (18b) des isolierten Gate-Treibers (18) nach dem Empfangen des Steuersignals; und
zum Weiterleiten des empfangenen Steuersignals an einen Eingangsanschluss (25) des isolierten Gate-Treibers (18) mit einer ersten vordefinierten Verzögerung (T1).

7. Luftfahrzeug-Festkörper-Leistungsregler (8) nach Anspruch 6, wobei die Verzögerungsschaltung (50) ferner konfiguriert ist zum
Stoppen des Weiterleitens des Steuersignals an den Eingangsanschluss (25) des isolierten Gate-Treibers (18) ohne erhebliche Verzögerung, wenn kein Steuersignal mehr an dem Steueranschluss (46) des Luftfahrzeug-Festkörper-Leistungsreglers (8) empfangen wird; und
Fortsetzen des Zuführens des Aktivierungssignals zu der Gate-Treiber-Stromversorgungs-Schaltschaltung (32) für eine zweite vordefinierte Verzögerung (T2), wenn kein Steuersignal mehr an dem Steueranschluss (46) des Luftfahrzeug-Festkörper-Leistungsreglers (8) empfangen wird.

8. Luftfahrzeug-Festkörper-Leistungsregler (8) nach Anspruch 6 oder 7,
wobei die erste vordefinierte Verzögerung (T1) in dem Bereich zwischen 1 Mikrosekunde und 50 Mikrosekunden liegt, wobei die erste vordefinierte Verzögerung (T1) insbesondere 10 ungefähr Mikrosekunden ist; und/oder
wobei die zweite vordefinierte Verzögerung (T2) in dem Bereich zwischen 1 Mikrosekunde und 50 Mikrosekunden liegt, wobei die zweite vordefinierte Verzögerung (T2) insbesondere ungefähr 10 Mikrosekunden ist.

9. Luftfahrzeug-Festkörper-Leistungsregler (8) nach einem der vorhergehenden Ansprüche, wobei der mindestens eine Festkörperschalter (10) ein Feldeffekttransistor, insbesondere ein MOSFET, ist oder einen solchen einschließt.

10. Luftfahrzeug-Festkörper-Leistungsregler (8) nach einem der vorhergehenden Ansprüche, umfassend eine Vielzahl von Festkörperschaltern (10), eine Vielzahl von isolierten Gate-Treibern (18) und eine Vielzahl von Spannungsreglern (26).

11. Luftfahrzeug (1), umfassend mindestens eine elektrische Stromquelle und mindestens einen Luftfahrzeug-Festkörper-Leistungsregler (8) nach einem der vorhergehenden Ansprüche.

12. Verfahren zum Betreiben eines Luftfahrzeug-Festkörper-Leistungsreglers (8) zum Steuern der Zufuhr von elektrischer Energie zu einer elektrischen Last (6) in einem Luftfahrzeug, wobei die elektrische Last (6) zwischen einem Ausgangsanschluss (14) des Luftfahrzeug-Festkörper-Leistungsreglers (8) und einem Massepotential (GND) elektrisch verbunden ist;
wobei der Luftfahrzeug-Festkörper-Leistungsregler (8) umfasst:
einen Festkörperschalter (10), der zwischen einer Stromversorgungsleitung (12) und dem Ausgangsanschluss (14) des Luftfahrzeug-Festkörper-Leistungsreglers (8) angeordnet und mit diesen elektrisch verbunden ist, zum selektiven Zuführen oder Unterbrechen einer Zufuhr von elektrischer Energie, die eine erste Spannung (U1) aufweist, die zwischen der Stromversorgungsleitung (12) und dem Massepotential (GND) gemessen wird, zu der elektrischen Last (6) als Reaktion auf ein Steuersignal, das an einem Steueranschluss (46) des Luftfahrzeug-Festkörper-Leistungsreglers (8) bereitgestellt wird; wobei das Steuersignal eine zweite Spannung (U2) in Bezug auf die Stromversorgungsleitung (12) aufweist und die zweite Spannung (U2) als eine zusätzliche Spannung auf die erste Spannung (U1) in Bezug auf das Massepotential (GND) angelegt wird;
einen isolierten Gate-Treiber (18), der eine Eingangsseite (18a) und eine Ausgangsseite (18b) umfasst, wobei die Ausgangsseite (18b) von der Eingangsseite (18a) galvanisch isoliert ist und wobei ein Referenzpotential der Ausgangsseite (18b) des isolierten Gate-Treibers (18) mit dem Ausgangsanschluss (14) des Luftfahrzeug-Festkörper-Leistungsreglers (8) elektrisch gekoppelt ist;
wobei das Verfahren einschließt:
Zuführen einer Gate-Treiber-Versorgungsspannung (UG) zum Antreiben der Ausgangsseite (18b) des isolierten Gate-Treibers (18) zu der Ausgangsseite (18b) des isolierten Gate-Treibers (18) in Bezug auf das Referenzpotential;
und
nach dem Empfangen des Steuersignals an dem Steueranschluss (46) des Luftfahrzeug-Festkörper-Leistungsreglers (8), Zuführen eines Treibersignals von der Ausgangsseite (18b) des isolierten Gate-Treibers (18) zu dem Festkörperschalter (10).

13. Verfahren nach Anspruch 12, wobei das Verfahren zumindest vorübergehendes Begrenzen der Gate-Treiber-Versorgungsspannung (UG), die der Ausgangsseite (18b) des isolierten Gate-Treibers (18) zugeführt wird, umfasst.

14. Verfahren nach Anspruch 12 oder 13, ferner umfassend, wobei das Verfahren einschließt
Zuführen der Gate-Treiber-Versorgungsspannung (UG) zu der Ausgangsseite (18b) des isolierten Gate-Treibers (18), wenn das Steuersignal an dem Steueranschluss (46) des isolierten Gate-Treibers (18) empfangen wird; und
Unterbrechen der Zufuhr der Gate-Treiber-Versorgungsspannung (UG) zu der Ausgangsseite (18b) des isolierten Gate-Treibers (18), wenn kein Steuersignal an dem Steueranschluss (46) des isolierten Gate-Treibers (18) empfangen wird.

15. Verfahren nach Anspruch 14, wobei das Verfahren nach dem Empfangen des Steuersignals an dem Steueranschluss (46) des Luftfahrzeug-Festkörper-Leistungsreglers (8) einschließt:
Anlegen, ohne erhebliche Verzögerung, eines Aktivierungssignals an die Gate-Treiber-Stromversorgungs-Schaltschaltung (32) zum Aktivieren der Gate-Treiber-Stromversorgungs-Schaltschaltung (32); und
Weiterleiten eines Steuersignals an einen Eingangsanschluss (25) des isolierten Gate-Treibers (18) mit einer ersten vordefinierten Verzögerung (T1)
, wobei das Verfahren insbesondere einschließt:
sofortiges Stoppen zum Anlegen eines Steuersignals an den Eingangsanschluss (25) des isolierten Gate-Treibers (18), wenn kein Steuersignal mehr an dem Steueranschluss (46) des Luftfahrzeug-Festkörper-Leistungsreglers (8) empfangen wird;
Fortsetzen des Zuführens des Aktivierungssignals zu der Gate-Treiber-Stromversorgungs-Schaltschaltung (32) für eine zweite vordefinierte Verzögerung (T2), wenn kein Steuersignal mehr an dem Steueranschluss (46) des Luftfahrzeug-Festkörper-Leistungsreglers (8) empfangen wird.

## Revendications

1. Contrôleur de puissance à l'état solide d'un aéronef (8) configuré pour la commande de l'alimentation en énergie électrique d'une charge électrique (6) dans un aéronef (1), dans lequel la charge électrique (6) est connectée électriquement entre une borne de sortie (14) du contrôleur de puissance à l'état solide d'un aéronef (8) et un potentiel de masse (GND) ;
le contrôleur de puissance à l'état solide d'un aéronef (8) comprenant :
un commutateur à l'état solide (10), qui est agencé entre une ligne d'alimentation (12) et la borne de sortie (14) du contrôleur de puissance à l'état solide d'un aéronef (8) et électriquement connecté à celles-ci, et configuré pour fournir ou interrompre de manière sélective l'alimentation en énergie électrique ayant une première tension (U1) entre la ligne d'alimentation (12) et le potentiel de masse (GND), à la charge électrique (6) en réponse à un signal de commande fourni au niveau d'une borne de commande (46) du contrôleur de puissance à l'état solide d'un aéronef (8) ; dans lequel le signal de commande a une seconde tension (U2) par rapport à la ligne d'alimentation (12) et le contrôleur de puissance à l'état solide d'un aéronef (8) est configuré pour appliquer la seconde tension (U2) comme tension supplémentaire s'ajoutant à la première tension (U1) par rapport au potentiel de masse (GND) ; et
un pilote de grille isolé (18), comprenant un côté d'entrée (18a) et un côté de sortie (18b), dans lequel le côté de sortie (18b) est isolé galvaniquement du côté d'entrée (18a) et dans lequel un potentiel de référence du côté de sortie (18b) du pilote de grille isolé (18) est couplé électriquement à la borne de sortie (14) du contrôleur de puissance à l'état solide d'un aéronef (8) ;
dans lequel le pilote de grille isolé (18) est configuré pour recevoir le signal de commande sur son côté d'entrée (18a) et pour fournir un signal d'entraînement au commutateur à l'état solide (10) sur son côté de sortie (18b) lors de la réception du signal de commande sur son côté d'entrée (18a) ;
dans lequel le contrôleur de puissance à l'état solide d'un aéronef (8) est configuré pour fournir une tension d'alimentation de pilote de grille (UG) pour piloter le côté de sortie (18b) du pilote de grille isolé (18) au côté de sortie (18b) du pilote de grille isolé (18) par rapport au potentiel de référence.

2. Contrôleur de puissance à l'état solide d'un aéronef (8) selon la revendication 1, dans lequel le contrôleur de puissance à l'état solide d'un aéronef (8) comprend en outre un régulateur de tension (26), qui est configuré pour limiter au moins temporairement la tension d'alimentation de pilote de grille (UG) qui est appliquée au côté de sortie (18b) du pilote de grille isolé (18).

3. Contrôleur de puissance à l'état solide d'un aéronef (8) selon la revendication 1 ou 2, dans lequel la première tension (U1) est dans la plage de 25 V à 30 V, dans lequel la première tension (U1) est en particulier de 28 V ; et/ou dans lequel la seconde tension (U2) est dans la plage de 1 V à 5 V, dans lequel la seconde tension (U2) est en particulier de 3,3 V.

4. Contrôleur de puissance à l'état solide d'un aéronef (8) selon l'une quelconque des revendications 1 à 3,
dans lequel le régulateur de tension (26) comprend une diode Zener (28) et/ou au moins un transistor (30), en particulier au moins un transistor bipolaire (30),
dans lequel le régulateur de tension (26) est en particulier configuré pour limiter au moins temporairement la tension d'alimentation de pilote de grille (UG) à une tension dans la plage comprise entre 20 V et 30 V.

5. Contrôleur de puissance à l'état solide d'un aéronef (8) selon l'une quelconque des revendications précédentes, comprenant en outre :
un circuit de commutation d'alimentation de pilote de grille (32), qui est configuré pour activer et désactiver de manière sélective la fourniture de la tension d'alimentation de pilote de grille (UG) au côté de sortie (18b) du pilote de grille isolé (18) en réponse au signal de commande.

6. Contrôleur de puissance à l'état solide d'un aéronef (8) selon la revendication 5, comprenant en outre un circuit de temporisation (50), dans lequel le circuit de temporisation (50) est configuré
pour fournir un signal d'activation pour activer le circuit de commutation d'alimentation de pilote de grille (32) sans délai considérable afin de fournir de l'énergie électrique au côté de sortie (18b) du pilote de grille isolé (18) lors de la réception du signal de commande ; et
pour transmettre le signal de commande reçu à une borne d'entrée (25) du pilote de grille isolé (18) avec un premier délai prédéfini (T1).

7. Contrôleur de puissance à l'état solide d'un aéronef (8) selon la revendication 6, dans lequel le circuit de temporisation (50) est en outre configuré pour
cesser de transmettre le signal de commande à la borne d'entrée (25) du pilote de grille isolé (18) sans délai considérable, lorsqu'aucun signal de commande n'est plus reçu sur la borne de commande (46) du contrôleur de puissance à l'état solide d'un aéronef (8) ; et
continuer à fournir le signal d'activation au circuit de commutation d'alimentation de pilote de grille (32) pendant un second délai prédéfini (T2), lorsqu'aucun signal de commande n'est plus reçu sur la borne de commande (46) du contrôleur de puissance à l'état solide d'un aéronef (8).

8. Contrôleur de puissance à l'état solide d'un aéronef (8) selon la revendication 6 ou 7,
dans lequel le premier délai prédéfini (T1) est dans la plage comprise entre 1 microseconde et 50 microsecondes, dans lequel le premier délai prédéfini (T1) est en particulier d'environ 10 microsecondes ; et/ou
dans lequel le second délai prédéfini (T2) est dans la plage comprise entre 1 microseconde et 50 microsecondes, dans lequel le second délai prédéfini (T2) est en particulier d'environ 10 microsecondes.

9. Contrôleur de puissance à l'état solide d'un aéronef (8) selon l'une quelconque des revendications précédentes, dans lequel l'au moins un commutateur à l'état solide (10) est ou comporte un transistor à effet de champ, en particulier un MOSFET.

10. Contrôleur de puissance à l'état solide d'un aéronef (8) selon l'une quelconque des revendications précédentes, comprenant une pluralité de commutateurs à l'état solide (10), une pluralité de pilotes de grille isolés (18) et une pluralité de régulateurs de tension (26).

11. Aéronef (1) comprenant au moins une source d'énergie électrique et au moins un contrôleur de puissance à l'état solide d'un aéronef (8) selon l'une quelconque des revendications précédentes.

12. Procédé de fonctionnement d'un contrôleur de puissance à l'état solide d'un aéronef (8) pour la commande de l'alimentation en énergie électrique d'une charge électrique (6) dans un aéronef, la charge électrique (6) étant connectée électriquement entre une borne de sortie (14) du contrôleur de puissance à l'état solide d'un aéronef (8) et un potentiel de masse (GND) ;
dans lequel le contrôleur de puissance à l'état solide d'un aéronef (8) comprend :
un commutateur à l'état solide (10) agencé entre une ligne d'alimentation (12) et la borne de sortie (14) du contrôleur de puissance à l'état solide d'un aéronef (8) et électriquement connecté à celles-ci, pour fournir ou interrompre de manière sélective l'alimentation en énergie électrique ayant une première tension (U1), qui est mesurée entre la ligne d'alimentation (12) et le potentiel de masse (GND), à la charge électrique (6) en réponse à un signal de commande, qui est fourni au niveau d'une borne de commande (46) du contrôleur de puissance à l'état solide d'un aéronef (8) ; dans lequel le signal de commande a une seconde tension (U2) par rapport à la ligne d'alimentation (12) et la seconde tension (U2) est appliquée comme tension supplémentaire s'ajoutant à la première tension (U1) par rapport au potentiel de masse (GND) ;
un pilote de grille isolé (18), comprenant un côté d'entrée (18a) et un côté de sortie (18b), dans lequel le côté de sortie (18b) est isolé galvaniquement du côté d'entrée (18a) et dans lequel un potentiel de référence du côté de sortie (18b) du pilote de grille isolé (18) est couplé électriquement à la borne de sortie (14) du contrôleur de puissance à l'état solide d'un aéronef (8) ;
dans lequel le procédé comporte :
la fourniture d'une tension d'alimentation de pilote de grille (UG) pour piloter le côté de sortie (18b) du pilote de grille isolé (18) au côté de sortie (18b) du pilote de grille isolé (18) par rapport au potentiel de référence ;
et
lors de la réception du signal de commande sur la borne de commande (46) du contrôleur de puissance à l'état solide d'un aéronef (8), la fourniture d'un signal d'entraînement à partir du côté de sortie (18b) du pilote de grille isolé (18) au commutateur à l'état solide (10).

13. Procédé selon la revendication 12, dans lequel le procédé comprend la limitation, au moins temporairement, de la tension d'alimentation de pilote de grille (UG) qui est fournie au côté de sortie (18b) du pilote de grille isolé (18).

14. Procédé selon la revendication 12 ou 13, comprenant en outre, dans lequel le procédé comporte
la fourniture de la tension d'alimentation de pilote de grille (UG) au côté de sortie (18b) du pilote de grille isolé (18), lorsque le signal de commande est reçu sur la borne de commande (46) du pilote de grille isolé (18) ; et
l'interruption de la fourniture de la tension d'alimentation de pilote de grille (UG) au côté de sortie (18b) du pilote de grille isolé (18), lorsqu'aucun signal de commande n'est reçu sur la borne de commande (46) du pilote de grille isolé (18).

15. Procédé selon la revendication 14, dans lequel le procédé comporte, lors de la réception du signal de commande sur la borne de commande (46) du contrôleur de puissance à l'état solide d'un aéronef (8) :
l'application, sans délai considérable, d'un signal d'activation au circuit de commutation d'alimentation de pilote de grille (32) pour activer le circuit de commutation d'alimentation de pilote de grille (32) ; et
la transmission d'un signal de commande reçu à une borne d'entrée (25) du pilote de grille isolé (18) avec un premier délai prédéfini (T1)
,dans lequel le procédé comporte en particulier :
la cessation immédiate de l'application d'un signal de commande à la borne d'entrée (25) du pilote de grille isolé (18), lorsqu'aucun signal de commande n'est plus reçu sur la borne de commande (46) du contrôleur de puissance à l'état solide d'un aéronef (8) ;
le fait de continuer à fournir le signal d'activation au circuit de commutation d'alimentation de pilote de grille (32) pendant un second délai prédéfini (T2), lorsqu'aucun signal de commande n'est plus reçu sur la borne de commande (46) du contrôleur de puissance à l'état solide d'un aéronef (8).
